# EUROPÄISCHE PATENTSCHRIFT

(11) **EP 3 149 855 B1**
(45) Veröffentlichungstag und Bekanntmachung des Hinweises auf die Patenterteilung: **16.12.2020**
(21) Anmeldenummer: 15722998.0
(22) Anmeldetag: 07.05.2015
(51) Int. Cl.: H03K 17/955, H03K 17/96, E05B 81/76, G07C 9/00

(54) **SENSOREINRICHTUNG FÜR EIN KRAFTFAHRZEUG**
SENSOR DEVICE FOR A MOTOR VEHICLE
MOYEN DE DÉTECTION D'UN VÉHICULE AUTOMOBILE

(30) Priorität: 28.05.2014 DE 102014107559
(43) Veröffentlichungstag der Anmeldung: 05.04.2017
(73) Patentinhaber: Huf Hülsbeck & Fürst GmbH & Co. KG, 42551 Velbert (DE)
(72) Erfinder: BEXTERMÖLLER, Hubert, 45468 Mülheim a.d. R. (DE); VAN GASTEL, Peter, 42699 Solingen (DE); PESCHL, Andreas, 42555 Velbert (DE)
(74) Vertreter: Zenz Patentanwälte Partnerschaft mbB
(86) Internationale Anmeldenummer: PCT/EP2015/060097
(87) Internationale Veröffentlichungsnummer: WO 2015/180942

(56) Entgegenhaltungen:
- EP-A2- 2 243 906
- DE-A1-102005 055 888
- DE-A1-102008 044 067
- FR-A1- 2 942 637

## Beschreibung

Die Erfindung betrifft eine Sensoreinrichtung für ein Kraftfahrzeug, insbesondere eine Sensoreinrichtung zur kapazitiven Erfassung von Annäherungen eines Benutzers an die Sensoreinrichtung.

Die Sensoreinrichtung ist mit wenigstens einer Mehrlagenplatine ausgebildet, die mehrere Metallisierungsebenen aufweist. Eine kapazitive Sensorelektrode ist zur Detektion auf einer der Metallisierungsebenen ausgebildet. Mit der Sensorelektrode ist eine Steuereinrichtung gekoppelt, um die Sensorelektrode mit einer elektrischen Spannung gegenüber einem Bezugspotenzial zu beaufschlagen. Eine Auswerteeinrichtung erfasst Kapazitätsänderungen an der Sensorelektrode, um Annäherung eines Benutzers an die Sensorelektrode zu detektieren. Steuereinrichtung und Auswerteeinrichtung können dabei zu einer Einrichtung integriert sein.

Kapazitive Erfassungssysteme für Annäherungen sind in der Technik bekannt. Zwischen der Sensorelektrode, die auf ein vorgegebenes Potential gebracht wird und einer Referenzelektrode, z.B. der Fahrzeugmasse oder der Masse des unter dem Fahrzeug befindlichen Bodens bildet sich eine Kapazität aus. Diese Kapazität ist veränderbar, wenn sich in dem sensitiven Bereich der Sensoranordnung ein Körper bewegt, beispielsweise der Fuß eines Benutzers. Die Erfassung der Kapazität selbst ist in verschiedener Weise möglich. Beispielsweise kann als Messwert für die Kapazität eine Anzahl getakteter Entladevorgänge oder eine Entladezeitdauer verwendet werden. Beispielsweise ist auch aus der DE 196 17 038A1 eine kapazitive Erfassung einer Annäherung an einen Fahrzeugtürgriff bekannt.

Die DE 10 2012 109 034 A1 offenbart beispielsweise einen Fahrzeugtürgriff mit einer integrierten Sensoranordnung. Die Sensoranordnung verwendet eine mehrlagige Leiterplatte mit einer Sensorelektrode, die durch eine Mehrzahl von Leiterstrukturen in benachbarten Leiterplattenebenen mit Durchkontaktierungen gebildet ist.

Das Konzept der kapazitiven Annäherungsdetektion mit Hilfe einer Sensorelektrode, einer Schirmelektrode (auch Richtelektrode genannt) und einer Bezugselektrode ist ebenfalls in der Technik bekannt. Beispielsweise wird ein entsprechendes Konzept in der EP 2 568 605 offenbart. Auch die DE 10 2009 002 566 A1 offenbart eine Sensoranordnung mit verschiedenen Metallisierungsebenen und einer Sensorelektrode sowie einer Schirmelektrode.

Aus dem Dokumente DE 102005055888 A1 ist eine kapazitive Sensoreinrichtung bekannt, welche mehrere Elektroden aufweist, die in Lagen angeordnet sind. Die Funktionen der Elektroden können paarweise getauscht werden.

Die FR 2942637 A1 offenbart einen Türgriff mit einem kapazitiven Sensor.

Aus der DE 10 2008 044 067 A1 ist ein kapazitiver Annäherungssensor mit Schirm- und Diagnoseelektrode bekannt. Die Anordnung bietet eine Diagnosefunktion, da die Erfassungsfunktion der Sensorelektrode bei einer Potenzialvorgabe an der Diagnoseelektrode überprüft werden kann. Die Sensorelektrode hat dabei in Abhängigkeit von dem Potenzial der Diagnoseelektrode vorgegebene Signale zu liefern, um die Diagnose zu bestehen.

Sensorelektroniken der genannten Art werden beispielsweise verwendet, um die Annäherung einer Hand des Benutzers eines Fahrzeuges an den Türgriff oder die Heckklappe eines Fahrzeuges zu erfassen. Wird eine solche Annäherung erfasst, wird beispielsweise ein Funkdialog mit einem Zugangsschlüssel für das Fahrzeug von einer fahrzeugseitigen Elektronik gestartet.

Wie dem Stand der Technik und den vorstehend genannten Druckschriften zu entnehmen, wird die Sensorelektrode auf den Erfassungsbereich hin ausgerichtet.

Auf der zum Erfassungsbereich abgewandten Seite wird eine Schirmelektrode platziert, wobei die Schirmelektrode in ihrem Potenzial der Sensorelektrode nachgeführt wird oder gegenüber diesem Potenzial variiert wird. Ausgewertet wird jedoch die Kapazitätsänderung der Sensorelektrode, nicht die der Schirmelektrode. Hinter der Schirmelektrode kann eine Masseelektrode platziert sein, um als Bezugspotenzial für die Kapazitätserfassung zu dienen.

Moderne Fahrzeuge und Bediensysteme erfordern immer komplexere und auch flexiblere Bedienmöglichkeiten.

Aufgabe der Erfindung ist es daher, eine verbesserte Sensoranordnung für eine kapazitive Annäherungserfassung bereitzustellen.

Diese Aufgabe wird gelöst durch eine Sensoreinrichtung mit den Merkmalen des Patentanspruches 1.

Wesentliches Merkmal der Erfindung ist es, eine Mehrlagenplatine mit mehreren Metallisierungsebenen zu verwenden, die Elektrodenbereiche in verschiedenen Ebenen aufnimmt. Als Mehrlagenplatine ist jede Platinenanordnung mit mehreren Metallisierungsebenen aufzufassen. Es kann z.B. eine einzelne Platine mit metallisierter Vorder- und Rückseite gebildet sein. Auch mehr als zwei Metallisierungsebenen sind im Rahmen der Erfindung verwendbar. Unter einer Mehrlagenplatine ist in diesem Zusammenhang auch der Verbund aus mehreren Einzelplatinen zu verstehen, die zu einer mehrlagigen Anordnung verbunden sind, z.B. über ein Pressfit Verfahren.

Diese Elektrodenbereiche werden jedoch nicht mit einer starren Funktionalität ausgestattet. Verschiedene Elektrodenbereiche sind wechselnd ansteuerbar, so dass sie zeitweise unterschiedliche Funktionen erfüllen. In einer Art zeitlichen Multiplexbetrieb kann also ein Elektrodenbereich zeitweise als Sensorelektrode dienen und in einem anderen Zeitbereich und Erfassungsschema als Masseelektrode dienen oder als Schirmelektrode herangezogen werden. Die erfindungsgemäße Einrichtung weist mehrere Elektrodenbereiche auf, die sich beispielsweise teilweise überlappend in verschiedenen Ebenen befinden können und realisiert auf diese Weise mit zeitlich gemultiplexter Ansteuerung unterschiedliche Bedienschemata.

Wesentlich ist, dass auf mehreren der Metallisierungsebenen jeweils wenigstens ein flächiger Elektrodenbereich ausgebildet ist. Jeder der für die Erfindung herangezogenen Elektrodenbereiche ist mit einer elektronischen Steuereinrichtung gekoppelt, welche die Elektrodenbereiche mit unterschiedlicher Spannung beaufschlagen kann.

Eine Auswerteeinrichtung ist mit wenigstens einer Auswahl der Elektrodenbereiche gekoppelt, um Kapazitätsänderungen zu erfassen. Auswerteeinrichtung und Steuereinrichtung sind miteinander gekoppelt, um den Wechsel zwischen den Erfassungsschemata und den Ansteuerungen der Elektrodenbereichen zu synchronisieren. Sie können auch integriert ausgebildet sein, so dass eine Schaltung die Ansteuerung und die Auswertung realisiert. Eine Auswahl der Elektrodenbereiche wird mit unterschiedlichen Spannungen beaufschlagt und die Auswerteinrichtung wertet, je nach gerade aktuellem Ansteuerung-Auswerteschema, verschiedene Elektrodenbereiche als Sensorelektrode aus.

Mit der erfindungsgemäßen Einrichtung brauchen nicht mehrere Sensoreinrichtungen für die Erfassung unterschiedlicher Bedienkonzepte realisiert werden. Diese Bedienkonzepte werden mit einer multifunktionalen Elektrodenanordnung auf einer Mehrlagenplatine realisiert. Es werden dabei in einer Ebene galvanisch getrennte Bereiche zur Ansteuerung ausgebildet, beispielsweise um Betätigungen in einen Griffbereich in Abhängigkeit vom Betätigungspunkt entlang der Griffachse zu erfassen. Außerdem können die Richtungen der Detektion, ausgehend von der Platine, verändert und umgekehrt werden. Dies ist möglich, indem beispielsweise die Lagen für die Sensorelektrode und die Schirmelektrode sowie die Masseelektrode ihre Reihenfolge vertauschen. Wird eine derartige Mehrlagenplatine also beispielsweise in einem Fahrzeugtürgriff angeordnet, so kann die Platine mit ihren Deckseiten einerseits in Richtung der Innenseite des Türgriffs und andererseits in Sichtrichtung der Außenseite orientiert werden. Durch den Wechsel der Funktionsebenen der Metallisierungsbereiche kann der Detektionsbereich einmal zur Innenseite des Türgriffes hin ausgerichtet werden und in einem zeitlichen Multiplexverfahren auch zeitweise zur Außenseite des Türgriffes. Beispielsweise können damit sowohl der Öffnungswunsch des Bedieners beim Eingreifen der Hand in die Innenseite der Tür als auch der Schließwunsch, beispielsweise beim Auflegen der Hand auf die Außenseite des Griffes, detektiert werden.

In einer einfachen Gestaltung weist eine Platine zwei Metallisierungsebenen auf, deren Funktion als Sensorelektrode und Masseelektrode im zeitlichen Ablauf gewechselt wird, um die Detektionsrichtung umzusteuern. Eine andere einfache Gestaltung verwendet drei Metallisierungsebenen, von denen die mittlere als Schirmelektrode beibehalten wird, die außenliegenden Elektroden aber im zeitlichen Wechsel die Funktionen als Sensor- und Masseelektrode tauschen. Es wird im weiteren deutlich, dass auch eine größere Anzahl an Metallisierungsebenen verwendet werden kann.

Erfindungsgemäß sind nicht nur in unterschiedlichen Ebenen der Mehrlagenplatinen Metallisierungsbereiche als Elektrodenbereiche für einen kapazitiven Sensor ausgebildet, es sind auch in einer Ebene mehrere getrennte Elektrodenbereiche ausgebildet, die einzeln ansteuerbar oder einzeln auswertbar sind.

Grundsätzlich ist eine besonders gute Sensierung möglich, wenn eine als Sensor wirkende Elektrode, oder ein Sensorelektrodenverbund aus mehreren Elektrodenflächen, möglichst ganzflächig von einer Schirmelektrode geschirmt wird und diese Schirmung mit einer Masseelektrode geschützt ist. Entsprechend können die mehreren Elektrodenbereiche jeder Ebene derartige Sensorelektroden, Schirmelektroden oder Masseelektroden durch Zusammenschalten bilden.

In einer solchen Gestaltung kann beispielsweise ein Detektionsbereich vorgesehen sein, der für die gezielte Betätigung durch Auflegen eines Daumens oder Fingers auf einen Griffabschnitt eine Detektion vornimmt.

Solche getrennten Sensorelektroden in einer Ebene können, wie vorstehend erwähnt, in einem anderen Schema zusammen angesteuert werden, um eine gemeinsame Masseelektrode oder Schirmelektrode zu bilden.

All diese verschiedenen Erfassungsschemata mit den wechselnden Elektrodenfunktionen können in zeitlicher Folge zyklisch durchlaufen werden. Allerdings kann auch eine zeitabhängige Ansteuerung dergestalt erfolgen, dass die Funktionen der Elektrodenbereiche in Abhängigkeit vom Fahrzeugzustand gewählt werden. Ist beispielsweise das Fahrzeug entriegelt, werden die Sensoren und Elektrodenbereiche derart angesteuert, dass nur eine Verriegelungsfunktion detektiert wird. Anders herum wird auf eine Entriegelungssensierung geschaltet, sofern das Fahrzeug sich im verriegelten Zustand befindet.

Im Rahmen der Erfindung ist es durchaus möglich, mehrere Elektrodenbereiche auf unterschiedlichen Ebenen zu Funktionseinheiten zusammenzufassen, beispielsweise um sie in einen Zeitbereich mit derselben Funktionalität zu versehen und auch mit derselben Spannung zu beaufschlagen.

Beispielsweise kann eine Schirmelektrode auf diese Weise über mehrere Ebenen der Mehrlagenplatine ausgedehnt werden und eine Sensorelektrode auf diese Weise gleichsam umklammern oder einfassen.

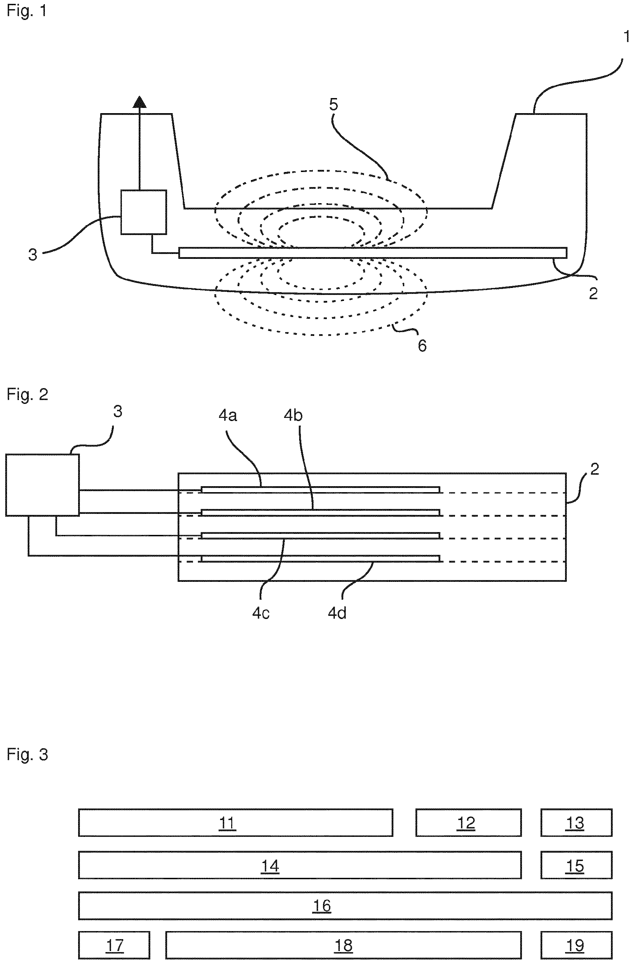

Die Erfindung wird nun anhand der beiliegenden Zeichnung näher erläutert
Figur 1 zeigt einen stilisierten Türgriff 1 für ein Kraftfahrzeug, der mit einer erfindungsgemäßen Sensoranordnung ausgestattet ist. In dem Türgriff ist in der Handhabe, also dem zu umgreifenden Bereich bei der Türöffnung, eine Mehrlagenplatine 2 angeordnet. Auf der Mehrlagenplatine 2 sind mehrere Ebenen mit Sensorelektrodenbereichen ausgebildet, wie im Weiteren beschrieben wird. Eine Steuer- und Auswerteeinrichtung 3 ist mit der Platine 2 und den darauf angeordneten Elektrodenbereichen gekoppelt. Die Steuer- und Auswerteeinrichtung 3 ist über einen Kabelbaum mit der fahrzeugseitigen zentralen Steuereinheit verbunden.

In Figur 1 ist das Wirkprinzip dargestellt, wonach mit ein und derselben Mehrlagenplatine 2 und auch denselben Elektrodenbereichen unterschiedliche Sensorfunktionen und Erfassungsbereiche erzielt werden. Bei Schaltung der Sensorelektroden durch die Steuer- und Auswerteeinrichtung 3 gemäß einem ersten Schema wird ein Detektionsbereich 5 realisiert, dessen Feldlinienbereich in der Figur 1 mit einer ersten gebrochenen Liniendarstellung angedeutet ist. Greift ein Benutzer in diesen Bereich im Inneren des Türgriffs hinein, so wird dies durch die Sensorelektrodenanordnung detektiert und eine entsprechende Fahrzeugfunktion kann ausgelöst werden. Schaltet die Steuer- und Auswerteeinrichtung 3 in die Sensorelektroden auf der Mehrlagenplatine 2 jedoch gemäß einem zweiten Schema an, so wird durch die Sensorelektroden ein Feldlinienverlauf 6 realisiert, der durch eine zweite Art von gebrochenen Linien dargestellt ist. Die Feldlinienverläufe 5 und 6 werden also zeitlich versetzt und nicht gleichzeitig realisiert.

Figur 2 zeigt in vergrößerter schematischer Ansicht die Steuer- und Auswerteeinrichtung 3 und die Kopplung an die Mehrlagenplatine 2 und die darin angeordneten Elektrodenbereiche. In der Platine 2 sind mehrere Elektrodenebenen ausgebildet und metallisierte Elektrodenbereiche 4a, 4b, 4c und 4d angeordnet. Um die Feldlinienausbildung mit einem Detektionsbereich oberhalb der in Figur 2 dargestellten Platine zu realisieren wird beispielsweise Elektrode 4a als Sensorelektrode angesteuert, also mit einem vorgegebenen Spannung gegenüber einer Bezugselektrode beaufschlagt und durch die Auswerteschaltung überwacht. Die Elektrode 4b dient dann als Schirmelektrode, wobei sie beispielsweise auf demselben Potenzial geführt wird wie die Sensorelektrode 4a, jedoch Kapazitätsänderungen nur bei der Sensorelektrode 4a überwacht werden, nicht jedoch bei der Schirmelektrode 4b. Der Elektrodenbereich 4c wird in dieser Konfiguration potenzialfrei (floating) gehalten und der Elektrodenbereich 4d wird mit Masse gekoppelt. Auf diese Weise wird ein nach oben gerichteter Detektionsbereich realisiert (Bereich 5 in Fig. 1).

Zeitlich versetzt oder durch rasche Umschaltung kann der Detektionsbereich in seiner Ausrichtung nach unten (Bereich 6 in Fig. 1) verändert werden. In diesem Fall dient die Elektrode 4d als Sensorelektrode mit zugehörigem Potenzial und zugehöriger Auswertung. Die Elektrode 4c kann in diesem Beispiel potenzialfrei gehalten werden während die Elektrode 4b als Schirmelektrode auf demselben Potenzial geführt wie die Sensorelektrode 4d, jedoch ohne Kapazitätsüberwachung. Die Elektrode 4a kann gemäß diesem Schema mit dem Massepotenzial gekoppelt sein.

Es ist ersichtlich, dass dieselben Elektrodenbereiche in zeitlichem Versetz unterschiedliche Elektrodenfunktionalitäten übernehmen.

Figur 3 zeigt ein weiteres Ausführungsbeispiel, bei dem eine Schichtanordnung auf einer Mehrlagenplatine in stilisierter Form dargestellt ist. Eine solche Anordnung kann auch in einer entsprechenden Griffanordnung für die Heckklappe oder die Seitentür eines Fahrzeuges untergebracht werden.

Es sind Elektrodenbereiche 11 bis 19 auf vier unterschiedlichen Ebenen in der Mehrlagenplatine ausgebildet. Diese Elektrodenbereiche sind wiederum mit einer Steuer- und Auswerteeinrichtung gekoppelt welche hier nicht dargestellt ist.

Gemäß einem ersten Funktionsschema werden mehrere Elektrodenbereiche, in diesem Beispiel die Bereiche 13, 15 und 16 mit einer Schirmspannung gekoppelt, während der Bereich 11 als Sensorelektrode geschaltet ist. Die seitliche Anordnung der Elektrodenbereiche 13 und 15, zusätzlich zu dem Elektrodenbereich 16 fasst die Wirkung der Sensorelektrode 11 rahmenartig ein. Die Elektrode 18 kann in diesem Schema als Masseelektrode geschaltet sein.

In einem zweiten Schema, welches zeitversetzt zu dem vorangehend beschriebenen Schema aktiviert wird, erhalten die Elektroden andere Funktionen oder werden andere Elektrodenbereiche aktiviert. In diesem anderen Schema wird beispielsweise die Elektrode 14 mit einer Schirmspannung versehen während die Elektrode 18 als Sensorelektrode wirkt. Die Elektrodenbereiche 17 und 19 sind mit demselben Potenzial gekoppelt wie die Elektrode 14, so dass auch hier die Sensorelektrode 18 von einem Schirmspannungspotenzial, liegend an den Elektroden 14, 17 und 19 eingefasst ist. Die Elektrode 16 kann in diesem Schema potentialfrei bleiben, während beispielsweise die Elektrode 12 als Masseelektrode wirkt.

Gemäß einem zeitlich versetzt aktivierbaren weiteren Schema können die Elektroden 12, 13, 15, 19 aktiviert werden, um einen begrenzten Bereich zu erfassen. Beispielsweise kann die Elektrode 19 und dem Bereich für eine Daumenauflage am Griff platziert sein. Wird dann das Erfassungsschema zur Daumenauflageerkennung aktiviert, so dient Elektrode 19 als Sensor, die Elektroden 18 und 16 dienen als Schirmelektrode und Elektrode 15 dient als Masse.

Es ist ersichtlich, dass gemäß der Erfindung sowohl unterschiedliche Elektrodenbereiche auf derselben Ebene einer Mehrlagenplatine als auch auf unterschiedlichen Ebenen der Platine in zeitlich veränderbarer Weise funktional angesteuert werden. Mehrere Elektrodenbereiche können dabei zu Funktionseinheiten zusammengefasst werden. Wesentlich ist, dass einige der Elektrodenbereiche in unterschiedlichen Ansteuerungsschemata unterschiedliche Funktionen übernehmen.

## Patentansprüche

1. Sensoreinrichtung für ein Kraftfahrzeug, mit einer Mehrlagenplatine (2), auf der mehrere Metallisierungsebenen ausgebildet sind,
wobei eine kapazitive Sensorelektrode zur Detektion mit Hilfe einer kapazitiven Annäherungserfassung auf einer der Metallisierungsebenen ausgebildet ist,
wobei eine Steuereinrichtung (3) mit der Sensorelektrode gekoppelt ist, um die Sensorelektrode mit einer elektrischen Spannung gegenüber einem Bezugspotenzial zu beaufschlagen und eine Auswerteeinrichtung (3) eine Kapazitätsänderung der Sensorelektrode erfasst, um Annäherungen eines Benutzers an die Sensorelektrode zu detektieren, wobei auf mehreren der Metallisierungsebenen jeweils wenigstens ein flächiger Elektrodenbereich (11, 12, 13, 14, 15, 16, 17, 18, 19) ausgebildet ist, wobei jeder der Elektrodenbereiche mit der Steuereinrichtung (3) gekoppelt ist, so dass jeder der Elektrodenbereiche mit einer zugeordneten, individuellen elektrischen Spannung gegenüber einem Bezugspotenzial zu beaufschlagen ist,
wobei die Auswerteeinrichtung (3) mit wenigstens zwei der Elektrodenbereiche auf unterschiedlichen Metallisierungsebenen gekoppelt ist,
wobei die Auswerteeinrichtung und die Steuereinrichtung derart ausgebildet sind, dass wenigstens zwei der Elektrodenbereiche auf unterschiedlichen Metallisierungsebenen zeitlich abwechselnd als Sensorelektrode angesteuert und ausgewertet werden und wenigstens zwei der Elektrodenbereiche auf unterschiedlichen Metallisierungsebenen zeitlich abwechselnd als Masse angesteuert und ausgewertet werden, wobei in wenigstens einer Metallisierungsebene zwei getrennte Elektrodenbereiche (11, 12, 13; 14, 15; 17, 18, 19) ausgebildet sind, welche getrennt ansteuerbar oder auswertbar sind,
wobei die Steuerschaltung derart ausgebildet ist, dass wenigstens einer der gekoppelten Elektrodenbereiche zweitweise potenzialfrei (floating) schaltbar ist.

2. Sensoreinrichtung nach Anspruch 1, wobei die zwei Elektrodenbereiche auf unterschiedlichen Metallisierungsebenen welche abwechselnd als Sensorelektrode und Masseelektrode ansteuerbar sind identisch sind, so dass jede der Elektroden zeitweise als Sensorelektrode und zeitweise als Masseelektrode ansteuerbar ist.

3. Sensoranordnung nach einem der vorangehenden Ansprüche, wobei die Steuereinrichtung und die Auswerteeinrichtung derart ausgebildet sind, dass zeitversetzt Elektrodenbereiche in verschiedenen Ebenen der Mehrlagenplatine als Sensorelektrode geschaltet sind.

4. Sensoranordnung nach Anspruch 3, wobei die Steuereinrichtung und die Auswerteeinrichtung ausgebildet sind, so dass zunächst
ein Elektrodenbereich (4a) als Sensorelektrode geschaltet ist, dessen Ebene der Mehrlagenplatine einen ersten Abstand von einer ersten Außenseite der Mehrlagenplatine aufweist und gleichzeitig ein anderer Elektrodenbereich (4c) als Schirmelektrode geschaltet ist, dessen Ebene der Mehrlagenplatine einen zweiten Abstand von der Außenseite aufweist, wobei der zweite Abstand größer als der erste Abstand ist,
und zeitlich versetzt
ein Elektrodenbereich (4c) als Sensorelektrode geschaltet ist, dessen Ebene der Mehrlagenplatine einen dritten Abstand von der ersten Außenseite der Mehrlagenplatine aufweist, wobei der dritte Abstand größer als der erste Abstand ist,
und gleichzeitig ein anderer Elektrodenbereich (4b) als Schirmelektrode geschaltet ist, dessen Ebene der Mehrlagenplatine einen vierten Abstand von der Außenseite aufweist, wobei der vierte Abstand kleiner als der dritte Abstand ist,
so dass zeitlich versetzt die räumliche Abfolge von Sensorelektrode und Schirmelektrode gegenüber der Außenseite umgekehrt wird.

5. Sensoranordnung nach einem der vorangehenden Ansprüche, wobei die Elektrodenbereiche wenigstens paarweise und wenigstens teilweise in einer Richtung senkrecht zu der Platinenebene überlappen.

6. Sensoranordnung nach einem der vorangehenden Ansprüche, wobei wenigstens ein Elektrodenbereich in einer Ebene als Sensorelektrode schaltbar ist, ein Elektrodenbereich in einer anderen Ebene als Schirmelektrode schaltbar ist und ein Elektrodenbereich in einer weiteren, anderen Ebene als Masseelektrode schaltbar ist.

## Claims

1. Sensor device for a motor vehicle, with a multilayer board (2) on which several metallization layers are formed,
wherein a capacitive sensor electrode for detection by means of capacitive proximity detection is formed on one of the metallization planes,
wherein a control means (3) is coupled to the sensor electrode to apply an electrical voltage to the sensor electrode with respect to a reference potential and an evaluation means (3) detects a change in capacitance of the sensor electrode to detect approaches of a user to the sensor electrode,
wherein at least one flat electrode region (11, 12, 13, 14, 15, 16, 17, 18, 19) is formed on each of a plurality of the metallization planes, each of the electrode regions being coupled to the control means (3) so that to each of the electrode regions an assigned, individual electrical voltage relative to a reference potential is applied,
wherein the evaluation means (3) is coupled to at least two of the electrode regions on different metallization levels,
wherein the evaluation means and the control means are designed in such a way that at least two of the electrode regions on different metallization levels are alternately driven and evaluated in time as sensor electrode and at least two of the electrode regions on different metallization levels are alternately driven and evaluated in time as ground,
wherein two separate electrode regions (11, 12, 13; 14, 15; 17, 18, 19) are formed in at least one metallization plane, which can be controlled or evaluated separately, wherein the control circuit is designed in such a way that at least one of the coupled electrode regions can be switched floating.

2. Sensor device according to claim 1, wherein the two electrode regions are identical on different metallization planes which can be driven alternately as sensor electrode and ground electrode, so that each of the electrodes can be driven temporarily as sensor electrode and temporarily as ground electrode.

3. Sensor device according to one of the preceding claims, wherein the control means and the evaluation means are designed in such a way that electrode regions in different planes of the multilayer board are connected as sensor electrode with a time offset.

4. Sensor device according to claim 3, wherein the control means and the evaluation means are designed so that first
an electrode region (4a) is connected as a sensor electrode, the plane of the multilayer board having a first distance from a first outer side of the multilayer board, and at the same time another electrode region (4c) is connected as a shield electrode, the plane of the multilayer board having a second distance from the outer side, the second distance being greater than the first distance,
and at a different time
an electrode region (4c) is connected as a sensor electrode, the plane of the multilayer board having a third distance from the first outer side of the multilayer board, the third distance being greater than the first distance,
and at the same time another electrode region (4b) is connected as a shield electrode, the plane of the multilayer board having a fourth distance from the outside, the fourth distance being smaller than the third distance,
so that the spatial sequence of the sensor electrode and shield electrode is reversed with respect to the outside.

5. Sensor device according to any of the foregoing claims, wherein the electrode regions overlap at least in pairs and at least partially in a direction perpendicular to the plane of the circuit board

6. Sensor device according to one of the preceding claims, wherein at least one electrode region in one plane is switchable as a sensor electrode, one electrode region in another plane is switchable as a shield electrode and one electrode region in another, different plane is switchable as a ground electrode.

## Revendications

1. Dispositif de détection pour un véhicule automobile, comportant un circuit imprimé multicouche (2) sur lequel sont formés plusieurs plans de métallisation,
dans lequel une électrode de détection capacitif est formée sur l'un des plans de métallisation pour la détection au moyen d'une détection de proximité capacitive,
dans lequel un dispositif de commande (3) est couplé à l'électrode de détection pour appliquer une tension électrique à l'électrode de détection par rapport à un potentiel de référence et dans lequel un dispositif d'évaluation (3) détecte un changement de la capacité de l'électrode de détection pour détecter les approches d'un utilisateur vers l'électrode de détection,
dans lequel au moins une zone d'électrode plate (11, 12, 13, 14, 15, 16, 17, 18, 19) est formée sur chacun des nombreux plans de métallisation, chacune des zones d'électrode étant couplée au dispositif de commande (3) de sorte que chacune des zones d'électrode doit être soumise à une tension électrique individuelle attribuée par rapport à un potentiel de référence,
dans lequel le dispositif d'évaluation (3) est couplé à au moins deux des zones d'électrode de plans de métallisation différents,
dans lequel le dispositif d'évaluation et le dispositif de commande se présentent de telle manière qu'au moins deux des zones d'électrode situées à des plans de métallisation différents sont alternativement commandées et évaluées comme électrode de détection et au moins deux des zones d'électrode situées à des plans de métallisation différents sont alternativement commandées et évaluées comme terre,
dans laquelle deux zones d'électrodes séparées (11, 12, 13; 14, 15; 17, 18, 19) sont formées dans au moins un plan de métallisation, qui peut être contrôlé ou évalué séparément,
dans lequel le circuit de commande se présente de telle manière qu'au moins une des zones d'électrodes couplées peut être commutée en mode flottant.

2. Dispositif de détection selon la revendication 1, dans lequel les deux zones d'électrode sont identiques sur des plans de métallisation différents qui peuvent être commandées alternativement comme électrode de détection et électrode de terre, de sorte que chacune des électrodes peut être commandée temporairement comme électrode de détection et temporairement comme électrode de terre.

3. Dispositif de détection selon l'une des revendications précédentes, dans lequel le dispositif de commande et le dispositif d'évaluation se présentent de telle manière que des zones d'électrodes situées dans différents plans du circuit imprimé multicouche sont connectées en tant qu'électrodes de capteurs avec un décalage temporel.

4. Dispositif de détection selon la revendication 3, dans lequel le dispositif de commande et le dispositif d'évaluation se présentent de telle manière que d'abord
une zone d'électrode (4a) est connectée comme électrode de détection, le plan du circuit imprimé multicouche ayant une première distance par rapport à un premier côté extérieur du circuit imprimé multicouche, et en même temps une autre zone d'électrode (4c) est connectée comme électrode de blindage, le plan du circuit imprimé multicouche ayant une deuxième distance par rapport au côté extérieur, la deuxième distance étant supérieure à la première,
et décalé dans le temps
une zone d'électrode (4c) est connectée en tant qu'électrode de détection dont le plan du circuit imprimé multicouche présente une troisième distance par rapport au premier côté extérieure du circuit imprimé multicouche , la troisième distance étant supérieure à la première,
et en même temps une autre zone d'électrode (4b) est connectée comme électrode de blindage, dont le plan du circuit imprimé multicouche a une quatrième distance par rapport à l'extérieur, la quatrième distance étant plus petite que la troisième,
de sorte que la séquence spatiale de l'électrode de détection et de l'électrode de blindage est inversée par rapport à l'extérieur avec un décalage dans le temps.

5. Dispositif de détection selon l'une des revendications précédentes, dans lequel les zones d'électrodes se chevauchent au moins par paires et au moins partiellement dans une direction perpendiculaire au plan du circuit imprimé

6. Dispositif de détection selon l'une des revendications précédentes, dans lequel au moins une zone d'électrode dans un plan est commutable comme électrode de détection, une zone d'électrode dans un autre plan est commutable comme électrode de blindage et une zone d'électrode dans un autre plan différent est commutable comme électrode de terre.
